# EUROPÄISCHE PATENTSCHRIFT

(11) **EP 2 288 912 B1**
(45) Veröffentlichungstag und Bekanntmachung des Hinweises auf die Patenterteilung: **29.05.2019**
(21) Anmeldenummer: 09765815.7
(22) Anmeldetag: 15.06.2009
(51) Int. Cl.: G01N 29/02, G01N 29/24, G01N 29/036, H03H 9/17, H01L 41/083

(54) **ANORDNUNG EINES PIEZOAKUSTISCHEN RESONATORS AUF EINEM AKUSTISCHEN SPIEGEL EINES SUBSTRATS, VERFAHREN ZUM HERSTELLEN DER ANORDNUNG UND VERWENDUNG DER ANORDNUNG**
ARRANGEMENT OF A PIEZOACOUSTIC RESONATOR ON AN ACOUSTIC MIRROR OF A SUBSTRATE, METHOD FOR THE MANUFACTURE OF THE ARRANGEMENT AND USE OF THE ARRANGEMENT
AGENCEMENT D'UN RÉSONATEUR PIÉZOACOUSTIQUE SUR UN MIROIR ACOUSTIQUE D'UN SUBSTRAT, PROCÉDÉ POUR PRODUIRE UN TEL AGENCEMENT ET UTILISATION DE CE DERNIER

(30) Priorität: 20.06.2008 DE 102008029378
(43) Veröffentlichungstag der Anmeldung: 02.03.2011
(73) Patentinhaber: Siemens Aktiengesellschaft, 80333 München (DE)
(72) Erfinder: PITZER, Dana, 85716 Unterschleissheim (DE); SCHREITER, Matthias, 81379 München (DE)
(86) Internationale Anmeldenummer: PCT/EP2009/057341
(87) Internationale Veröffentlichungsnummer: WO 2009/153235

(56) Entgegenhaltungen:
- WO-A-2004/017063
- JP-A- 2004 187 204
- US-A1- 2006 232 361
- US-A1- 2007 007 851
- US-A1- 2007 152 777

## Beschreibung

Die Erfindung betrifft eine Anordnung mindestens eines piezoakustischen Resonators auf eine Substratoberfläche eines Substrats, wobei der Resonator mindestens eine piezoelektrische Schicht, eine Elektrode und mindestens eine weitere Elektrode aufweist, die derart aneinander angeordnet sind, dass eine bestimmte elektrische Ansteuerung der Elektroden zu einer Resonanzschwingung des Resonators mit einer Resonanzfrequenz führt, die Substratoberfläche des Substrats von einem im Substrat integrierten akustischen Spiegel zur akustischen Isolation des Substrats und des Resonators voneinander gebildet ist und mindestens eine Auswerteeinrichtung zur Bestimmung der Resonanzfrequenz des Resonators vorhanden ist. Daneben werden ein Verfahren zum Herstellen der Anordnung und eine Verwendung der Anordnung angegeben.

Der piezoakustische Resonator ist beispielsweise ein piezoakustischer Dünnfilmresonator (Film Bulk Acoustic Resonator, FBAR). Ein derartiger Dünnfilmresonator ist beispielsweise in der WO 2004/017063 A2 beschrieben. Der Dünnfilmresonator besteht beispielsweise aus zwei Elektrodenschichten und einer zwischen den Elektrodenschichten angeordneten piezoelektrischen Schicht in Form einer Piezokeramikschicht. Die Piezokeramikschicht ist eine polykristalline Schicht aus Zinkoxid-Einkristallen. Die Elektrodenschichten sind beispielsweise aus Platin. Die Elektrodenschichten und die Piezokeramikschicht sind derart aneinander angeordnet, dass eine elektrische Ansteuerung der Elektrodenschichten mit einem elektrischen Wechselfeld zu einer Schwingung des Resonators führt. Bei Ansteuerung mit einem bestimmten elektrischen Wechselfeld kommt es zu einer Resonanzschwingung mit einer bestimmten Resonanzfrequenz. Die Resonanzfrequenz der Schwingung hängt unter anderem von den Schichtdicken der Schichten ab. Aufgrund einer Orientierung der Zinkoxid-Einkristalle kann der Dünnfilmresonator zu Longitudinaldickenschwingungen und zu Scherdickenschwingungen angeregt werden.

Zum Erzeugen der Schichten des Dünnfilmresonators auf dem Substrat, beispielsweise einem Siliziumsubstrat, wird ein Dampfabscheideverfahren (Abscheidung aus der Gasphase) durchgeführt. Zur Bestimmung der Resonanzfrequenz ist eine Auswerteeinrichtung im Substrat integriert. Nicht angegeben ist in diesem Stand der Technik, wie die Auswerteeinrichtung mit den Elektrodenschichten des Dünnfilmresonators elektrisch kontaktiert wird.

Die US 2007/152777 A1 beschreibt einen integrierten Schaltkreis mit einem akustischen Resonator, bei welchem eine Schicht mit einem hohen Impedanzwert und eine darauf angebrachte Schicht mit einem niedrigen akustischen Impedanzwert durch einen Metallbock unterbrochen wird, welcher eine Elektrode elektrisch mit einer Verbindungsebene koppelt.

Die US 2006/0232361 A1 offenbart einen Filter mit akustischen Resonatoren, welche seitlich mit einer Verbindung kontaktiert werden.

Aufgabe der vorliegenden Erfindung ist es, aufzuzeigen, wie die Elektroden eines piezoakustischen Resonators platzsparend und sicher elektrisch kontaktiert werden können, so dass die Resonanzfrequenz des Resonators bestimmt werden kann.

Zur Lösung der Aufgabe wird im Anspruch 1 eine Anordnung mindestens eines piezoakustischen Resonators auf einer Substrat-Oberfläche eines Substrats angegeben, wobei der Resonator mindestens eine piezoelektrische Schicht, eine Elektrode und mindestens eine weitere Elektrode aufweist, die derart aneinander angeordnet sind, dass eine bestimmte elektrische Ansteuerung der Elektrode zu einer Resonanzschwingung des Resonators mit einer Resonanzfrequenz führt, die Substratoberfläche des Substrats von einem im Substrat integrierten akustischen Spiegel zur akustischen Isolation des Substrats und des Resonators voneinander gebildet ist und mindestens eine Auswerteeinrichtung zur Bestimmung der Resonanzfrequenz des Resonators vorhanden ist. Die Anordnung ist dadurch gekennzeichnet, dass die Auswerteeinrichtung und mindestens eine der Elektroden über eine elektrische Leiterbahn elektrisch leitend miteinander verbunden sind und die elektrische Leiterbahn durch eine Spiegel-Öffnung des akustischen Spiegels hindurchgeführt ist. Die elektrische Leiterbahn dient als Signal- oder Masseleitung des piezoakustischen Resonators.

Zur Lösung der Aufgabe wird auch ein Verfahren zum Herstellen der Anordnung mit folgenden Verfahrensschritten angegeben:
a) Bereitstellen eines Substrats mit einem die Substrat-Oberfläche bildenden akustischen Spiegel und einer im Spiegel vorhandenen Spiegel-Öffnung, über die ein Ausleseschaltkreis der Auswerteeinrichtung elektrisch leitend verbindbar ist,
und b) Anordnen der elektrischen Leiterbahn in der Spiegel-Öffnung derart, dass der Ausleseschaltkreis und die elektrische Leiterbahn elektrisch leitend verbunden werden.

In Bezug auf das Verfahren werden zum Bereitstellen des Substrats insbesondere folgende weiteren Verfahrensschritte durchgeführt: a') Bereitstellen eines Substrats mit einem im Substrat integrierten Ausleseschaltkreis, a'') Aufbringen des akustischen Spiegels auf dem Substrat über dem Ausleseschaltkreis derart, dass der akustische Spiegel die Substrat-Oberfläche des Substrats bildet, und a"') Erzeugen der Spiegel-Öffnung im akustischen Spiegel derart, dass der Ausleseschaltkreis zugänglich wird. Dabei wir der piezoakustische Resonator bevorzugt vor dem Erzeugen der Spiegelöffnung auf dem akustischen Spiegel angeordnet.

Dabei wird ein akustischer Spiegel mit einem Spiegel-Schicht-Stapel verwendet, der abwechselnd übereinander gestapelte Schichten aufweist, die im Vergleich zueinander unterschiedliche akustische Impedanzen aufweisen und die jeweils eine Schichtdicke aufweisen, die etwa einem Viertel einer Resonanzwellenlänge λ einer Resonanzschwingung des resultierenden Resonators entspricht. Zum Abscheiden der Schichten wird vorzugsweise auf ein Dampfabscheideverfahren, beispielsweise ein chemisches Dampfabscheideverfahrens (Chemical Vapour Deposition, CVD) oder auf ein physikalisches Dampfabscheideverfahren (Physical Vapour Deposition, PVD) zurückgegriffen. Es resultiert ein akustischer Spiegel in Form eines Bragg-Reflektors mit λ/4-dicken Schichten. Besonders geeignet hat sich ein im Zusammenhang mit Silizium-Substraten eine Schichtfolge aus abwechselnd übereinander gestapelten Schichten aus Silizium-Dioxid und Wolfram ergeben.

Dabei weist ein seitlicher Rand (Flanke) der Spiegel-Öffnung des akustischen Spiegels eine elektrische Öffnungs-Isolationsschicht mit Öffnungs-Isolationsmaterial auf, auf der die elektrische Leiterbahn aufgebracht ist.

Es weist die oberste, die Substratoberfläche bildende Schicht des Spiegel-Schicht-Stapels eine elektrische Spiegel-Isolationsschicht mit elektrischem Spiegel-Isolationsmaterial auf. Das Spiegel-Isolationsmaterial und das Öffnungs-Isolationsmaterial sind im Wesentlichen gleich. Dies bedeutet, dass die Spiegel-Isolationsschicht ebenso wie die Öffnungs-Isolationsschicht aus Silizium-Dioxid ist. Es sind dabei eine Schichtdicke der Spiegel-Isolationsschicht und die Schichtdicke der Öffnungs-Isolationsschicht im Wesentlichen gleich. Bevorzugt beträgt die Schichtdicke etwa ein Viertel der Resonanzwellenlänge λ der Resonanzschwingung des resultierenden Resonators.

Dabei bilden die Spiegel-Isolationsschicht und die Öffnungs-Isolationsschicht eine zusammenhängende Gesamt-Isolationsschicht. Insbesondere wird dazu nach dem Erzeugen der Spiegel-Öffnung die Öffnungs-Isolationsschicht in der Spiegel-Öffnung und während des Aufbringens der Öffnungs-Isolationsschicht die Spiegel-Isolationsschicht derart aufgebracht, dass die Spiegel-Isolationsschicht die Substratoberfläche des Substrats bildet. Die Isolationsschichten werden in einem einzigen Verfahrensschritt erzeugt. Prinzipiell ist es aber auch möglich, die Isolationsschichten nacheinander und auch aus unterschiedlichen Isolationsmaterialien herzustellen, solange das Spiegel-Isolationsmaterial und das Öffnungs-Isolationsmaterial Silizium-Dioxid ist, wobei die Spiegel-Isolationsschicht und die Öffnungs-Isolationsschicht eine zusammenhängende Gesamt-Isolationsschicht bilden.

Nach dem Aufbringen der Spiegel-Isolationsschicht wird der Resonator auf die durch die Spiegel-Isolationsschicht gebildete Substratoberfläche des Substrats aufgebracht.

Gemäß einer besonderen Ausgestaltung ist der Resonator ein Dünnfilmresonator. Die Elektroden sind Elektrodenschichten. Die Elektrodenschichten und die piezoelektrische Schicht können beliebig aneinander angeordnet sein. Vorzugsweise weist aber der Dünnfilmresonator einen Resonator-Schicht-Stapel auf. Dabei weist eine der Elektroden eine auf dem akustischen Spiegel aufgebrachte Elektrodenschicht auf. Darüber ist die piezoelektrische Schicht aufgebracht. Eine weitere Elektrode weist eine unmittelbar auf der piezoelektrischen Schicht aufgebrachte weitere Elektrodenschicht auf. Somit resultiert ein Resonator-Schicht-Stapel, bei dem zwischen den Elektrodenschichten eine piezoelektrische Schicht des Resonators angeordnet ist.

Vorzugsweise ist die piezoelektrische Schicht eine polykristalline Schicht aus Zinkoxid oder Aluminiumnitrid. Bei geeigneter Orientierung der polaren C-Achsen der entsprechenden Einkristalle ist es möglich, den piezoakustischen Resonator zu Dickenscherschwingungen anzuregen.

Verwendung findet die Anordnung als physikalischer Transducer einer Vorrichtung zur Detektion einer Substanz eines Fluids. Dabei wird der Effekt ausgenutzt, dass durch Belegung einer Resonator-Oberfläche des Resonators eine Masse des Resonators zunimmt und damit der Resonanzfrequenz des Dünnfilmresonators abnimmt. Aufgrund der Scherdickenschwingungen ist es möglich, ein Fluid in Form einer Flüssigkeit mit Hilfe der vorliegenden Anordnung zu untersuchen.

Folgende Vorteile der Erfindung sind hervorzuheben:
- Mit Hilfe der Erfindung ist ein platzsparender Aufbau der Anordnung aus piezoakustischem Resonator auf einem Substrat möglich.
- Insbesondere führt die Verwendung einer Gesamt-Isolationsschicht, die sich aus der obersten Silizium-Dioxid-Schicht des Spiegelschicht-Stapels des akustischen Spiegels und der Öffnungs-Isolationsschicht zusammensetzt, zu einer zuverlässigen elektrischen Isolation der elektrischen Leiterbahn von metallischen Spiegelschichten (Wolfram-Spiegelschichten).
- Mit der Schichtdicke von λ/4 der Gesamt-Isolationsschicht, die im Hinblick auf den akustischen Spiegel ausgewählt ist, kommt es gleichzeitig zu einer guten kapazitiven Entkopplung der elektrischer Leitungsbahn und des akustischen Spiegels voneinander. Im Fall einer Gesamt-Isolationsschicht aus SiO₂ wird bei einer Resonanzfrequenz von unter 1 GHz eine Schichtdicke der Gesamt-Isolationsschicht von über 1 µm und damit eine effiziente elektrische Isolation erzielt.
- Zusätzliche Isolationsschichten sind nicht nötig. Dies führt zu relativ geringen Herstellungskosten.
- Die Nutzung der obersten Spiegelschicht als Isolations-schicht führt zu einer teilweisen Planarisierung des Aufbaus des akustischen Spiegels, was vorteilhaft für eventuell notwendige, nachfolgende photolithographische Prozesse beim Aufbau des Resonators ist.

Anhand eines Ausführungsbeispiels und der dazugehörigen Figuren wird die Erfindung im Folgenden näher beschrieben. Die Figuren sind schematisch und stellen keine maßstabsgetreuen Abbildungen dar.

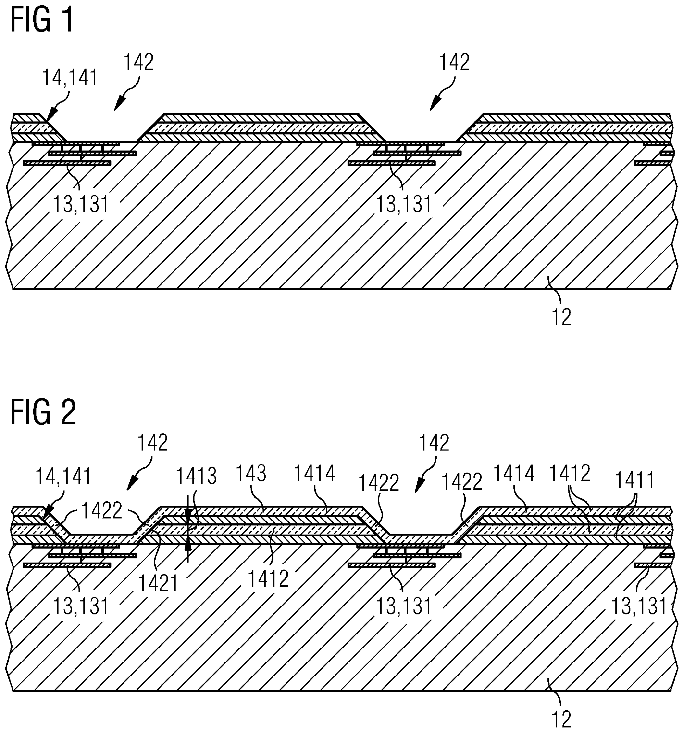

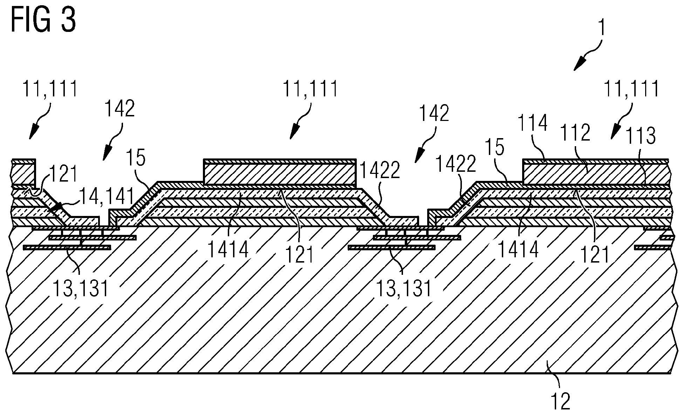

Die Figuren 1 bis 3 zeigen in einem seitlichen Querschnitt jeweils einen Ausschnitt einer Entwicklungsstufe, die während des Verfahrens zum Herstellen der Anordnung eines piezoakustischen Resonators auf eine Substratoberfläche eines Substrats durchlaufen werden.

Gemäß dem Ausführungsbeispiel weist die Anordnung 1 ein Resonator-Array aus drei piezoakustische Resonatoren 11 auf jeweils einer Substratoberfläche 121 eines Substrats 12 auf. Die piezoakustischen Resonatoren sind piezoakustische Dünnfilmresonatoren. Diese Resonatoren bestehen aus einem Resonator-Schicht-Stapel 11 mit einer Elektrode beziehungsweise Elektrodenschicht 113, einer weiteren Elektrode beziehungsweise weiteren Elektrodenschicht 114 und einer zwischen den Elektrodenschichten angeordneten piezoelektrischen Schicht 112. Die piezoelektrische Schicht ist eine polykristalline Keramikschicht Zinkoxid (Zinkoxid-Film). Die polaren C-Achsen der Zinkoxid-Einkristalle des Zinkoxid-Films sind gegen die Substratoberfläche verkippt. Dadurch lässt sich der Resonator durch elektrische Ansteuerung der Elektrodenschichten nicht nur zu Longitudinaldickenschwingungen, sondern auch zu Scherdickenschwingungen anregen. Eine Schichtdicke des Zinkoxid-films beträgt etwa 0,5 µm. Die Elektrodenschichten sind aus Platin. Die obere Elektrodenschicht ist etwa 100 nm und die untere Elektrodenschicht 890 nm dick. Eine laterale Ausdehnung des Dünnfilmresonators beträgt etwa 200 µm.

Die Substratoberfläche 121 des Substrats 12 wird von einem im Substrat integrierten akustischen Spiegel 14 zur akustischen Isolation des Substrats und des Resonators voneinander gebildet. Der akustische Spiegel weist einen Spiegel-Schicht-Stapel 141 auf. Dieser Spiegel-Schicht-Stapel stellt einen Bragg-Reflektor dar, bei dem Schichten mit niedrigerer akustischer Impedanz 1411 und Schichten mit höherer akustischer Impedanz 1412 übereinander gestapelt sind. Die Schichten mit niedrigerer akustischer Impedanz sind aus Siliziumdioxid. Die Schichten mit höherer akustischer Impedanz sind aus Wolfram. Die Schichtdicken dieser Schichten unterschiedlicher akustischer Impedanz betragen etwa ein Viertel einer Resonanzwellenlänge der Resonanzschwingung des Resonators.

Im Substrat ist eine Auswerteeinrichtung 13 zur Bestimmung der Resonanzfrequenz des Resonators integriert. Die Auswerteeinrichtung verfügt über einen Ausleseschaltkreis 131. Dieser Ausleseschaltkreis ist mit mindestens einer der Elektroden elektrisch leitend verbunden. Dazu ist eine elektrische Leiterbahn 15 durch Spiegel-Öffnungen 142 geführt. Die Leiterbahn ist aus Aluminium. Ein seitlicher Rand (Flanke) 1421 der Spiegel-Öffnung verfügt über eine Öffnungs-Isolationsschicht 1422 zur elektrischen Isolierung der elektrischen Leiterbahn 15 und der elektrisch leitenden Wolframschichten 1411. Die Öffnungs-Isolationsschicht ist aus Siliziumdioxid.

Die oberste Schicht des Spiegel-Schicht-Stapels bildet eine Spiegel-Isolationsschicht 1414. Diese Spiegel-Isolationsschicht und die Öffnungs-Isolationsschicht bilden zusammen die Gesamt-Isolationsschicht 143. Die Spiegel-Isolationsschicht bildet die Substratoberfläche des Substrats. Auf der Spiegel-Isolationsschicht sind die Elektrodenschichten der Dünnfilmresonatoren unmittelbar aufgebracht.

Zum Herstellen der Anordnung werde folgende Verfahrensschritte durchgeführt: a) Bereitstellen eines Substrats aus Silizium mit einem die Substratoberfläche 121 bildenden akustischen Spiegel 14 und einer im Spiegel vorhandenen Spiegel-Öffnung 142, über die ein im Substrat integrierter Ausleseschaltkreis der Auswerteeinrichtung elektrisch leitend verbindbar ist, und b) Anordnen der elektrischen Leiterbahn in der Spiegel-Öffnung derart, dass der Ausleseschaltkreis und die elektrische Leiterbahn elektrisch leitend miteinander verbunden sind.

Zum Bereitstellen des Substrats werden folgende weiteren Verfahrensschritte durchgeführt: a') Bereitstellen des Substrats mit einem im Substrat integrierten Ausleseschaltkreis, a'') Aufbringen des akustischen Spiegels auf dem Substrat über dem Ausleseschaltkreis derart, dass der akustische Spiegel die Substratoberfläche des Substrats bildet, und a"') Erzeugen der Spiegel-Öffnung im akustischen Spiegel derart, dass der Ausleseschaltkreis zugänglich wird.

Zum Erzeugen des akustischen Spiegels werden die einzelnen Schichten unterschiedlicher akustischer Impedanz über ein Dampfabscheideverfahren aufgebracht. Zum Bereitstellen der Spiegel-Öffnungen wird nach dem Aufbringen des Spiegel-Schicht-Stapels Material des Spiegel-Schicht-Stapels an den Stellen wieder entfernt, unter denen sich die Ausleseschaltkreise befinden.

Anschließend wird in einem Dampfabscheideverfahren die Gesamt-Isolationsschicht aus Siliziumdioxid, bestehend aus der Öffnungs-Isolationsschicht und der Spiegel-Isolationsschicht aufgebracht. Dies geschieht in einem einzigen Verfahrensschritt. Die Gesamt-Isolationsschicht erfüllt zwei Funktionen: Die Gesamt-Isolationsschicht trägt als Bestandteil des akustischen Spiegels zur akustischen Isolation der Resonatoren und des Substrats voneinander bei. Darüber hinaus fungiert es als elektrischer Isolator.

Nachfolgend werden die Resonatoren aufgebracht. Dies erfolgt in bekannter Weise durch Abscheiden der entsprechenden Schichten aus der Gasphase.

Anschließend wird eine Öffnung im Bereich der Öffnungs-Isolationsschicht erzeugt. Durch diese Öffnung hindurch erfolgt die elektrische Kontaktierung einer der Elektrodenschichten des Resonators und des jeweiligen Ausleseschaltkreises.

Verwendung findet die Anordnung als physikalischer Transducer einer Vorrichtung zur Detektion einer Substanz eines Fluids. Aufgrund der Möglichkeit, den Resonator nicht nur zu Longitudinaldickenschwingungen, sondern auch zu Scherdickenschwingungen anzuregen, eignet sich die Anordnung für die Verwendung in einem Fluid in Form einer Flüssigkeit.

## Patentansprüche

1. Anordnung (1) mindestens eines piezoakustischen Resonators auf einer Substratoberfläche (121) eines Substrats (12), wobei
- der Resonator mindestens eine piezoelektrische Schicht (112), eine Elektrode (113) und mindestens eine weitere Elektrode (114) aufweist, die derart aneinander angeordnet sind, dass eine bestimmte elektrische Ansteuerung der Elektroden zu einer Resonanzschwingung des Resonators mit einer Resonanzfrequenz führt,
- die Substratoberfläche des Substrats von einem im Substrat integrierten akustischen Spiegel (14) zur akustischen Isolation des Substrats und des Resonators voneinander gebildet ist und
- mindestens eine Auswerteeinrichtung (13) zur Bestimmung der Resonanzfrequenz des Resonators vorhanden ist,
- die Auswerteeinrichtung und zumindest eine der Elektroden über eine elektrische Leiterbahn (15) elektrisch leitend miteinander verbunden sind und
- die elektrische Leiterbahn durch eine Spiegel-Öffnung (142) des akustischen Spiegel hindurch geführt ist, wobei
- ein seitlicher Rand (1421) der Spiegel-Öffnung des akustischen Spiegels eine elektrische Öffnungs-Isolationsschicht (1422) mit Öffnungs-Isolationsmaterial aufweist, auf der die elektrische Leiterbahn aufgebracht ist, und wobei
- der akustische Spiegel einen Spiegel-Schicht-Stapel (141) aufweist, bei dem abwechselnd übereinander Schichten (1411, 1412) mit im Vergleich zueinander niedrigerer akustischer Impedanz und höherer akustischer Impedanz gestapelt sind, wobei
- die Schichten jeweils eine Schichtdicke aufweisen, die etwa einem Viertel einer Resonanzwellenlänge der Resonanzschwingung des Resonators entspricht, wobei
- die oberste, die Substratoberfläche des Substrats bildende Schicht des Spiegel-Schicht-Stapels eine elektrische Spiegel-Isolationsschicht (1411) mit elektrischem Spiegel-Isolationsmaterial aufweist und das Spiegel-Isolationsmaterial und das Öffnungs-Isolationsmaterial Silizium-Dioxid ist, wobei
- eine Schichtdicke der Spiegel-Isolationsschicht und die Schichtdicke der Öffnungs-Isolationsschicht im Wesentlichen gleich sind, und
- die Spiegel-Isolationsschicht und die Öffnungs-Isolationsschicht eine zusammenhängende Gesamt-Isolationsschicht (143) bilden.

2. Anordnung nach Anspruch 1, wobei die Auswerteeinrichtung einen im Substrat integrierten Ausleseschaltkreis (131) aufweist, der über die elektrische Leiterbahn mit der Elektrode elektrisch leitend verbunden ist.

3. Anordnung nach einem der Ansprüche 1 bis 2, wobei der Resonator ein Dünnfilmresonator ist.

4. Anordnung nach einem der Ansprüche 1 bis 3, wobei eine der Elektroden eine unmittelbar auf dem akustischen Spiegel aufgebrachte Elektrodenschicht aufweist.

5. Anordnung nach einem der Ansprüche 1 bis 4, wobei die weitere Elektrode eine weitere Elektrodenschicht aufweist, die auf der piezoelektrischen Schicht aufgebracht ist.

6. Anordnung nach Anspruch 5, wobei die weitere Elektrodenschicht derart auf der piezoelektrischen Schicht aufgebracht ist, dass die Elektrodenschicht, die weitere Elektrodenschicht und die piezoelektrische Schicht einen Resonator-Schicht-Stapel (111) bilden, bei dem die piezoelektrische Schicht zwischen den Elektrodenschichten angeordnet ist.

7. Anordnung nach Anspruch 1, wobei die Schichten (1411) mit niedrigerer akustischer Impedanz Silizium-Dioxid aufweisen.

8. Anordnung nach Anspruch 1, wobei die Schichten (1412) mit höherer akustischer Impedanz elementares Wolfram aufweisen.

9. Anordnung nach Anspruch 1, wobei das Öffnungs-Isolationsmaterial und das Spiegel-Isolationsmaterial Silizium-Dioxid aufweisen.

10. Verfahren zum Herstellen einer Anordnung nach einem der Ansprüche 1 bis 9 mit folgenden Verfahrensschritten:
a) Bereitstellen eines Substrats mit einem die Substratoberfläche bildenden akustischen Spiegel und einer im Spiegel vorhandenen Spiegel-Öffnung über die ein Ausleseschaltkreis der Auswerteeinrichtung elektrisch leitend verbindbar ist, und
b) Anordnen der elektrischen Leiterbahn in der Spiegel-Öffnung derart, dass der Ausleseschaltkreis und die elektrische Leiterbahn elektrisch leitend verbunden werden.

11. Verfahren nach Anspruch 10, wobei zum Bereitstellen des Substrats folgende weiteren Verfahrensschritte durchgeführt werden:
a') Bereitstellen eines Substrats mit einem im Substrat integrierten Ausleseschaltkreises,
a") Aufbringen des akustischen Spiegels auf dem Substrat über dem Ausleseschaltkreis derart, dass der akustische Spiegel die Substratoberfläche des Substrats bildet, und
a"') Erzeugen der Spiegel-Öffnung im akustischen Spiegel derart, dass der Ausleseschaltkreis zugänglich wird.

12. Verfahren nach Anspruch 10 oder 11, wobei ein akustischer Spiegel mit einem Spiegel-Schicht-Stapel verwendet wird, der abwechselnd übereinander gestapelte Schichten aufweist, die im Vergleich zueinander niedrigere oder höhere akustische Impedanzen aufweisen und die jeweils eine Schichtdicke aufweisen, die etwa einem Viertel einer Resonanzwellenlänge der Resonanzschwingung des resultierenden Resonators entspricht.

13. Verfahren nach einem der Ansprüche 10 bis 12, wobei nach dem Erzeugen der Spiegel-Öffnung die Öffnungs-Isolations-Schicht und während des Aufbringens der Öffnungs-Isolations-Schicht die Spiegel-Isolations-Schicht derart aufgebracht wird, dass die Spiegel-Isolations-Schicht die Substratoberfläche des Substrats bildet.

14. Verfahren nach Anspruch 13, wobei nach dem Aufbringen der Spiegel-Isolations-Schicht der Resonator auf die durch die Spiegel-Isolations-Schicht gebildete Substratoberfläche des Substrats aufgebracht wird.

15. Verwendung einer Anordnung nach einem der Ansprüche 1 bis 9 als physikalischen Transducer einer Vorrichtung zur Detektion einer Substanz eines Fluids.

## Claims

1. Arrangement (1) of at least one piezoacoustic resonator on a substrate surface (121) of a substrate (12), wherein
- the resonator has at least one piezoelectric layer (112), an electrode (113) and at least one further electrode (114) which are arranged in relation to one another in such a way that a specific electrical activation of the electrodes leads to a resonance oscillation of the resonator at a resonance frequency,
- the surface of the substrate is formed by an acoustic mirror (14) integrated in the substrate for the purpose of acoustically insulating the substrate and the resonator from each other, and
- at least one evaluation device (13) is provided for the purpose of determining the resonance frequency of the resonator,
- the evaluation device and at least one of the electrodes are connected to each other in an electrically conductive manner by way of an electric conductor track (15) and
- the electric conductor track is routed through a mirror opening (142) of the acoustic mirror, wherein
- a lateral edge (1421) of the mirror opening of the acoustic mirror has an electrical opening insulation layer (1422) comprising opening insulation material on which the electric conductor track is applied, and wherein
- the acoustic mirror has a mirror layer stack (141) in which layers (1411, 1412) having lower acoustic impedance and higher acoustic impedance compared with one another are stacked alternately one on top of another, wherein
- each of the layers has a layer thickness corresponding to approximately a quarter of a resonance wavelength of the resonance oscillation of the resonator, wherein
- the topmost layer of the mirror layer stack forming the surface of the substrate has an electric mirror insulation layer (1411) comprising electric mirror insulation material and the mirror insulation material and the opening insulation material are made of silicon dioxide, wherein
- a layer thickness of the mirror insulation layer and the layer thickness of the opening insulation layer are essentially identical and
- the mirror insulation layer and the opening insulation layer form a cohesive overall insulation layer (143).

2. Arrangement according to claim 1, wherein the evaluation device has a readout circuit (131) integrated in the substrate which is connected to the electrode in an electrically conductive manner by way of the electric conductor track.

3. Arrangement according to one of claims 1 to 2, wherein the resonator is a thin-film resonator.

4. Arrangement according to one of claims 1 to 3, wherein one of the electrodes has an electrode layer applied directly on the acoustic mirror.

5. Arrangement according to one of claims 1 to 4, wherein the further electrode has a further electrode layer which is applied on the piezoelectric layer.

6. Arrangement according to claim 5, wherein the further electrode layer is applied on the piezoelectric layer in such a way that the electrode layer, the further electrode layer and the piezoelectric layer form a resonator layer stack (111) in which the piezoelectric layer is arranged between the electrode layers.

7. Arrangement according to claim 1, wherein the layers (1411) having lower acoustic impedance are made of silicon dioxide.

8. Arrangement according to claim 1, wherein the layers (1412) having higher acoustic impedance are made of elementary tungsten.

9. Arrangement according to claim 1, wherein the opening insulation material and the mirror insulation material include silicon dioxide.

10. Method for producing an arrangement according to one of claims 1 to 9, comprising the following method steps of:
a) providing a substrate with an acoustic mirror forming the substrate surface and a mirror opening present in the mirror via which a readout circuit of the evaluation device can be connected in an electrically conductive manner,
and
b) arranging the electric conductor track in the mirror opening in such a way that the readout circuit and the electric conductor track are connected in an electrically conductive manner.

11. Method according to claim 10, wherein the following further method steps are performed in order to provide the substrate:
a') providing a substrate with a readout circuit integrated in the substrate,
a'') mounting the acoustic mirror on the substrate over the readout circuit in such a way that the acoustic mirror forms the surface of the substrate, and
a"') creating the mirror opening in the acoustic mirror in such a way that the readout circuit is made accessible.

12. Method according to claim 10 or 11, wherein an acoustic mirror having a mirror layer stack is used which has layers stacked alternately one on top of another, which layers have lower or higher acoustic impedances compared with one another and each of which has a layer thickness corresponding to approximately a quarter of a resonance wavelength of the resonance oscillation of the resulting resonator.

13. Method according to one of claims 10 to 12, wherein the opening insulation layer is applied after the mirror opening is created and the mirror insulation layer is applied during the application of the opening insulation layer in such a way that the mirror insulation layer forms the surface of the substrate.

14. Method according to claim 13, wherein after the mirror insulation layer is applied the resonator is mounted onto the surface of the substrate formed by the mirror insulation layer.

15. Use of an arrangement according to one of claims 1 to 9 as a physical transducer of a device for detecting a substance of a fluid.

## Revendications

1. Agencement (1) d'au moins un résonateur piézoacoustique sur une surface de substrat (121) d'un substrat (12), dans lequel
- le résonateur comprend au moins une couche piézoélectrique (112), une électrode (113) et au moins une électrode supplémentaire (114), lesquelles sont disposées les unes sur les autres de telle sorte qu'une commande électrique déterminée des électrodes mène à une oscillation de résonance du résonateur avec une fréquence de résonance,
- la surface de substrat du substrat est formée d'un miroir acoustique (14) intégré dans le substrat pour l'isolation acoustique du substrat et du résonateur l'un par rapport à l'autre et
- au moins un dispositif d'évaluation (13) pour la détermination de la fréquence de résonance du résonateur est présent,
- le dispositif d'évaluation et au moins l'une des électrodes sont raccordés l'un à l'autre de manière électriquement conductrice par l'intermédiaire d'une ligne électrique conductrice (15) et
- la ligne électrique conductrice est guidée à travers une ouverture de miroir (142) du miroir acoustique, dans lequel
- un bord latéral (1421) de l'ouverture de miroir du miroir acoustique comprend une couche isolante électrique d'ouverture (1422) avec un matériau isolant d'ouverture, sur laquelle est appliquée la ligne électrique conductrice, et dans lequel
- le miroir acoustique comprend un empilement de couches de miroir (141) dans lequel sont empilées les unes au-dessus des autres en alternance des couches (1411, 1412) avec une impédance acoustique inférieure et une impédance acoustique supérieure comparativement l'une par rapport à l'autre, dans lequel
- les couches présentent respectivement une épaisseur de couche qui correspond à environ un quart d'une longueur d'onde de résonance de l'oscillation de résonance du résonateur, dans lequel
- la couche supérieure, formant la surface de substrat du substrat, de l'empilement de couches de miroir comprend une couche isolante électrique de miroir (1411) avec un matériau isolant électrique de miroir et le matériau isolant de miroir et le matériau isolant d'ouverture sont du dioxyde de silicium, dans lequel
- une épaisseur de couche de la couche isolante de miroir et l'épaisseur de couche de la couche isolante d'ouverture sont sensiblement égales, et
- la couche isolante de miroir et la couche isolante d'ouverture forment une couche isolante globale cohérente (143).

2. Agencement selon la revendication 1, dans lequel le dispositif d'évaluation comprend un circuit de lecture (131) intégré dans le substrat qui est raccordé de manière électriquement conductrice à l'électrode par l'intermédiaire de la ligne électrique conductrice.

3. Agencement selon l'une des revendications 1 à 2, dans lequel le résonateur est un résonateur à film mince.

4. Agencement selon l'une des revendications 1 à 3, dans lequel l'une des électrodes comprend une couche d'électrode appliquée directement sur le miroir acoustique.

5. Agencement selon l'une des revendications 1 à 4, dans lequel l'électrode supplémentaire comprend une couche d'électrode supplémentaire qui est appliquée sur la couche piézoélectrique.

6. Agencement selon la revendication 5, dans lequel la couche d'électrode supplémentaire est appliquée sur la couche piézoélectrique de telle sorte que la couche d'électrode, la couche d'électrode supplémentaire et la couche piézoélectrique forment un empilement de couches de résonateur (111) dans lequel la couche piézoélectrique est disposée entre les couches d'électrode.

7. Agencement selon la revendication 1, dans lequel les couches (1411) avec une impédance acoustique inférieure comprennent du dioxyde de silicium.

8. Agencement selon la revendication 1, dans lequel les couches (1412) avec une impédance acoustique supérieure comprennent du tungstène élémentaire.

9. Agencement selon la revendication 1, dans lequel le matériau isolant d'ouverture et le matériau isolant de miroir comprennent du dioxyde de silicium.

10. Procédé pour la réalisation d'un agencement selon l'une des revendications 1 à 9 avec les étapes de procédé suivantes :
a) préparation d'un substrat avec un miroir acoustique formant la surface de substrat et une ouverture de miroir présente dans le miroir par l'intermédiaire de laquelle un circuit de lecture du dispositif d'évaluation est raccordable de manière électriquement conductrice, et
b) disposition de la ligne électrique conductrice dans l'ouverture de miroir de telle sorte que le circuit de lecture et la ligne électrique conductrice soient raccordés de manière électriquement conductrice.

11. Procédé selon la revendication 10, dans lequel pour la préparation du substrat, les étapes de procédé supplémentaires suivantes sont mises en oeuvre :
a') préparation d'un substrat avec un circuit de lecture intégré dans le substrat,
a") application du miroir acoustique sur le substrat au-dessus du circuit de lecture de telle sorte que le miroir acoustique forme la surface de substrat du substrat, et
a"') création de l'ouverture de miroir dans le miroir acoustique de telle sorte que le circuit de lecture soit accessible.

12. Procédé selon la revendication 10 ou la revendication 11, dans lequel un miroir acoustique est utilisé avec un empilement de couches de miroir qui comprend des couches empilées les unes au-dessus des autres en alternance, lesquelles présentent des impédances acoustiques inférieure ou supérieure comparativement l'une par rapport à l'autre et lesquelles présentent respectivement une épaisseur de couche qui correspond à environ un quart d'une longueur d'onde de résonance de l'oscillation de résonance du résonateur résultant.

13. Procédé selon l'une des revendications 10 à 12, dans lequel la couche isolante d'ouverture, après la création de l'ouverture de miroir, et la couche isolante de miroir, pendant l'application de la couche isolante d'ouverture, sont appliquées de telle sorte que la couche isolante de miroir forme la surface de substrat du substrat.

14. Procédé selon la revendication 13, dans lequel après l'application de la couche isolante de miroir, le résonateur est appliqué sur la surface de substrat, formée par la couche isolante de miroir, du substrat.

15. Utilisation d'un agencement selon l'une des revendications 1 à 9 en tant que transducteur physique d'un dispositif pour la détection d'une substance d'un fluide.
